# EUROPEAN PATENT APPLICATION

(11) **EP 1 473 770 A1**
(43) Date of publication of application: **03.11.2004**
(21) Application number: 03029188.4
(22) Date of filing: 18.12.2003
(51) Int. Cl.: H01L 23/532, H01L 21/312

(54) **Low dielectric constant interconnect insulator having fullerene additive**

(30) Priority: 18.12.2002 US 322868
(71) Applicant: TEXAS INSTRUMENTS INCORPORATED, Dallas Texas 75265 (US)
(72) Inventor: Large, Jeffrey L., Dallas 75243 (US); Edwards, Henry L., Garland 75044 (US)
(74) Representative: Holt, Michael

(57) **Abstract**

An embodiment of the invention is semiconductor material having interconnect insulating material, 9, that contains fullerenes, 11. Another embodiment of the invention is a method of templating the voids in a semiconductor interconnect insulator, 9, by adding fullerenes, 11, to dielectric material, 10.

## Description

### BACKGROUND OF THE INVENTION

This invention concerns a low dielectric constant interconnect insulator for a semiconductor device or wafer.

### BRIEF DESCRIPTION OF THE DRAWINGS

FIG. 1 shows a portion of semiconductor material in accordance with the present invention.
FIG. 2 shows a portion of the interconnect insulator in accordance with one embodiment of the present invention.
FIG. 3 shows a portion of the interconnect insulator in accordance with another embodiment of the present invention.

### DETAILED DESCRIPTION OF THE INVENTION

The quality of interconnect insulating material is improved by void templating. Several aspects of this invention are described below with reference to example applications for illustration. It should be understood that numerous specific details, relationships, and methods are set forth to provide a full understanding of the invention. One skilled in the relevant art, however, will readily recognize that the invention can be practiced without one or more of the specific details, or with other methods. In other instances, well-known structures or operations are not shown in detail to avoid obscuring the invention.

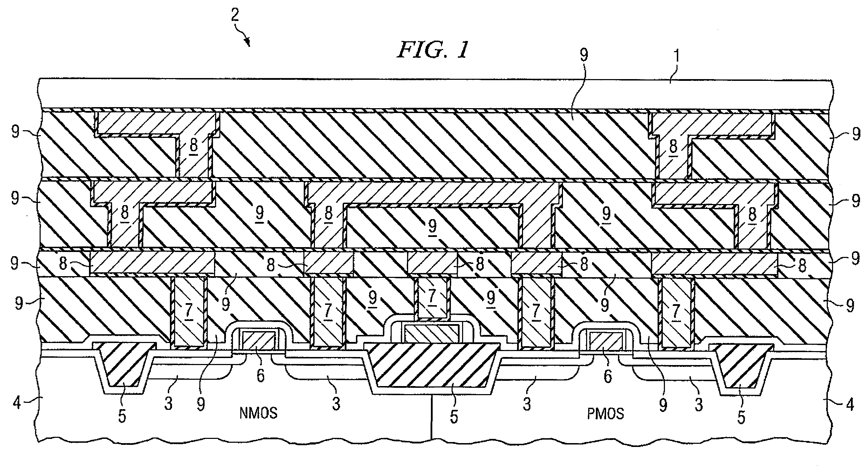

Referring to the drawings, FIG. 1 shows a portion, 2, of semiconductor material having a protective coating,1, in accordance with the present invention. Semiconductor portion, 2, includes numerous doped semiconductor regions. These doped semiconductor regions are n-type, and p-type regions that define the device sources or drains, 3, and the wells, 4. The areas of semiconductor portion, 2, labeled "STI" (Shallow Trench Isolation), 5, denote regions of electrical insulation. In addition, the areas of semiconductor portion, 2, labeled "gate", 6, denote the gate of an example field effect transistor ("FET").

Example contacts and first layer metal interconnects of semiconductor portion, 2, are also shown in FIG. 1. Specifically, "W", 7, and "Cu", 8, denotes conductive material made from tungsten and copper, respectively. This conductive material provides a plurality of contacts and first layer metal interconnects used to connect the example devices with other devices (not shown) on the semiconductor portion, 2. Lastly, interconnect insulating material, 9, is a dielectric that insulates the electrical activity occurring in the contacts and interconnects, 7 and 8. In summary, FIG. 1 shows two FETs, including the p-type and n-type material associated with the FETs and the STIs separating the FETs, along with the conductive, semiconductive, and insulating material forming other devices on the semiconductor that are not shown in cross-section.

In the best mode application, the starting dielectric material used to form the interconnect insulation, 9, is Spin-On-Dielectric ("SOD"). However, other starting materials such as Physical Vapor Deposition ("PVD") and Plasma Enhanced Chemical Vapor Deposition ("PECVD") are within the scope of this invention. Moreover, starting materials containing various nanotubes, porogens, or spacers are comprehended by this invention.

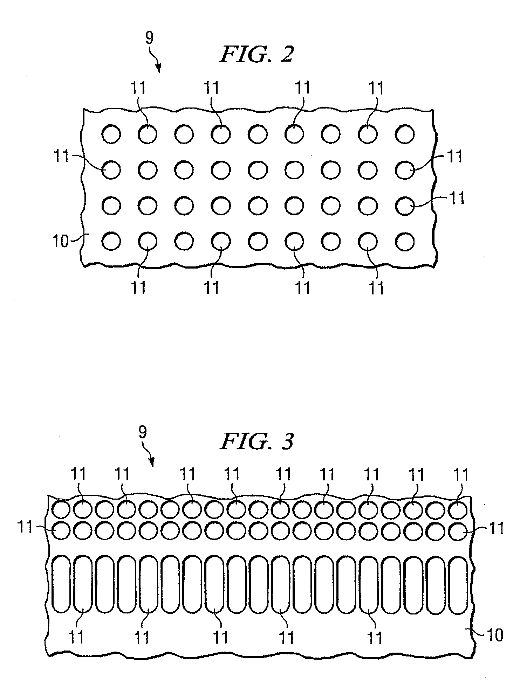

Referring again to the drawings, FIG. 2 shows interconnect insulation material, 9, in accordance with the invention. The interconnect insulating material, 9, includes the dielectric material SOD, 10. The dielectric constant of the SOD, 10, is lowered by templating, or designing, the location and shape of voids, 11. The void templating of the SOD, 10, is accomplished through the use of fullerenes, 11. In one application of the invention, the fullerenes, 11, are C60 Buckminsterfullerenes.

Buckminsterfullerenes are hollow, closed carbon molecules having a regular morphology. Furthermore, Buckminsterfullerenes will not agglomerate (and form larger void structures). Therefore, the insulating material, 9, will have a stable, strong, non-permeable, and predictable void morphology. It is within the scope of this invention to have fullerenes of various shapes and sizes. For example, a C70 size Buckminsterfullerene ball may be used instead of the C60 size Buckminsterfullerene ball. In addition, fullerenes of various topologies may be used, such as a tube or capsule. In the best mode application, as shown in exemplary fashion in FIG. 3, a variety of fullerenes may be placed in the insulating material, 9.

In the example application shown in FIG. 3, the insulating material, 9, is comprised of SOD, 10, with rows of tightly packed C60 Buckminsterfullerenes, 11, along the top surface, plus a row of capsule-shaped Buckminsterfullerenes, 11, in the middle section. The insulating material, 9, may be created by depositing layers of dielectric, each layer having a different composition of fullerenes that were added by fluid immersion.

Alternatively, the insulating material 9 may be created by using a Plasma-Enhanced Chemical Vapor Deposition ("PECVD") process or a High Density Plasma ("HDP") process. In either plasma chamber process, the desired fullerenes are injected into the plasma chamber during the deposition of the complimentary dielectric material, eventually forming the final insulating material 9. When desired, the fullerenes that are injected into the plasma chambers could be changed over time. Therefore, to create the example insulating material, 9, shown in FIG. 3, the capsule shaped fullerenes would first be injected into the plasma chamber after a base section of pure dielectric material has been deposited. Then later in the deposition process, the soccer-ball shaped fullerenes would be injected into the plasma chamber in place of the capsule shaped fullerenes.

Various modifications to the invention as described above are within the scope of the claimed invention. For example, the interconnect insulating material, 9, may be formed using deposition techniques other than those described above. In addition, the interconnect insulating material, 9, may have vertical sections having any combination of void morphologies. It is within the scope of this invention to use the interconnect insulating material, 9, in wafers having device structures entirely different from the example shown in FIG. 1. Similarly, the invention is applicable in semiconductor wafers having different, well and substrate technologies, dopant types, and transistor and metal types or configurations. Furthermore, the invention is applicable to other semiconductor technologies such as BiCMOS, bipolar, SOI , strained silicon, microelectrical mechanical system ("MEMS"), or SiGe.

While various embodiments of the present invention have been described above, it should be understood that they have been presented by way of example only, and not limitation. Numerous changes to the disclosed embodiments can be made in accordance with the disclosure herein without departing from the scope of the invention. Thus, the breadth and scope of the present invention should not be limited by any of the above described embodiments. Rather, the scope of the invention should be defined in accordance with the following claims and their equivalents.

## Claims

1. A semiconductor device comprising:
interconnect insulating material having a fullerene additive.

2. The semiconductor device of Claim 1 wherein said interconnect insulating material is PVD.

3. The semiconductor device of Claim 1 or 2 wherein said fullerene additive is a Buckminsterfullerene additive.

4. The semiconductor device of Claim 1 or 2 wherein said fullerene additive is a C60 Buckminsterfullerene additive.

5. The semiconductor device of Claim 1 or 2 wherein said fullerene additive is a capsule-shaped Buckminsterfullerene additive.

6. The semiconductor device of Claim 1 or 2 wherein said interconnect insulating material has more than one shape of fullerene additives.

7. The semiconductor device of Claim 1, 2 or 6 wherein said interconnect insulating material has more than one size of fullerene additives.

8. The semiconductor device of any one of Claims 1 to 7 wherein said interconnect insulating material also has porogens.

9. A method for templating the voids in a semiconductor interconnect insulator comprising:
adding fullerene molecules to a low dielectric constant material.

10. The method of claim 9 wherein said fullerene molecules are added to said low dielectric constant material by a fluid emersion process.

11. The method of claim 9 wherein said fullerene molecules are added to said low dielectric constant material by injecting said fullerene molecules to a plasma chamber.

12. The method of any one of claims 9 to 11 wherein said fullerene molecules are of various shapes.

13. The method of any one of claims 9 to 12 wherein said fullerene molecules are of various sizes.

14. The method of any one of Claims 9 to 13 wherein said low dielectric constant material is SOD.
